# EUROPÄISCHE PATENTSCHRIFT

(11) **EP 1 852 709 B1**
(45) Veröffentlichungstag und Bekanntmachung des Hinweises auf die Patenterteilung: **05.11.2008**
(21) Anmeldenummer: 07008490.0
(22) Anmeldetag: 26.04.2007
(51) Int. Cl.: G01R 33/34, G01R 33/30

(54) **Gekühlter NMR Probenkopf mit flexibler gekühlter Verbindungsleitung**
Cooled NMR probe head with flexible cooled coupler
Sonde RMN refroidie dotée d'un conduit de liaison flexible et refroidi

(30) Priorität: 03.05.2006 DE 102006020772
(43) Veröffentlichungstag der Anmeldung: 07.11.2007
(73) Patentinhaber: Bruker BioSpin AG, 8117 Fällanden (CH)
(72) Erfinder: Sacher, Marco, 8610 Uster (CH); Marek, Daniel, Dr., 5103 Möriken (CH); Leutenegger, Tobias, Dr., 8057 Zürich (CH); Baumann, Daniel Guy, Dr., 8057 Zürich (CH); Haueisen, Ralf, Dr., 76131 Karlsruhe (DE)
(74) Vertreter: Kohler Schmid Möbus

(56) Entgegenhaltungen:
- EP-A2- 1 471 363
- DE-A1- 19 648 253
- DE-C1- 19 720 677
- DE-C1- 19 946 371
- US-A- 5 508 613

## Beschreibung

Die Erfindung betrifft einen Magnetresonanz(=MR)-Probenkopf mit einer Detektionsvorrichtung mit mindestens einem von einer Kühlvorrichtung kryogen gekühlten Antennensystem, sowie mit einem gekühlten Vorverstärker in einem Vorverstärkergehäuse, welches örtlich getrennt von der Detektionsvorrichtung angeordnet ist, und mit einer thermisch isolierenden Verbindungseinrichtung, über die die Detektionsvorrichtung und das Vorverstärkergehäuse miteinander verbunden sind, wobei die Verbindungseinrichtung mindestens eine Kühlleitung für die Zu- und/ oder Rückleitung eines Kühl-Fluids, sowie mindestens eine HF-Leitung zur Übertragung der elektrischen Signale umfasst.

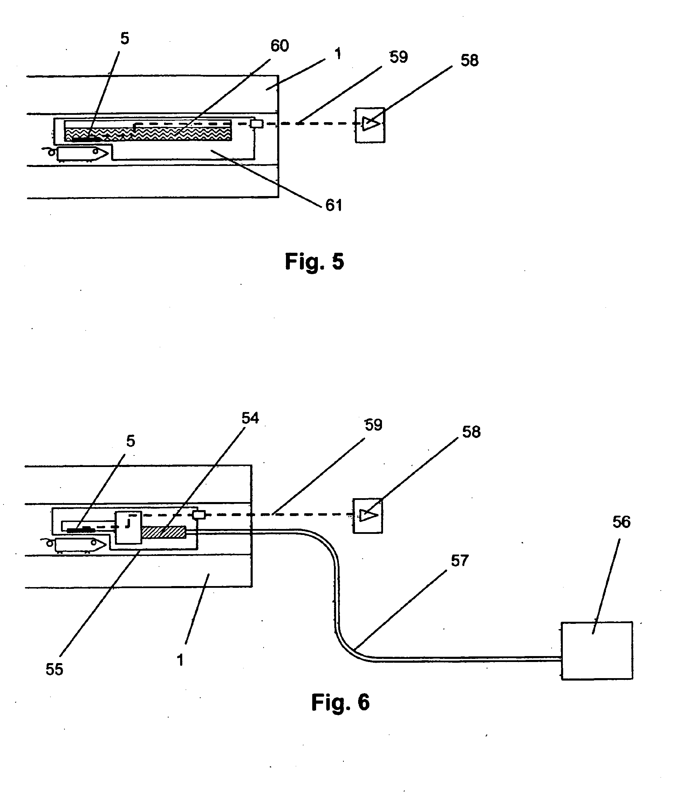

Ein derartiger Probenkopf ist beispielsweise aus [3] (siehe z.B. die darin enthaltene Fig.5) bekannt und wird für die Detektion von NMR Signalen aus einer Probe verwendet. Dabei ist die Empfangsspule gekühlt. Bei dieser Empfangsspule kann es sich um eine aus normal leitendem Metall, z.B. Kupfer oder Aluminium bestehende, oder aber eine solche aus Supraleitermaterialien handeln, insbesondere aus Hochtemperatur-Supraleitern (HTSC).

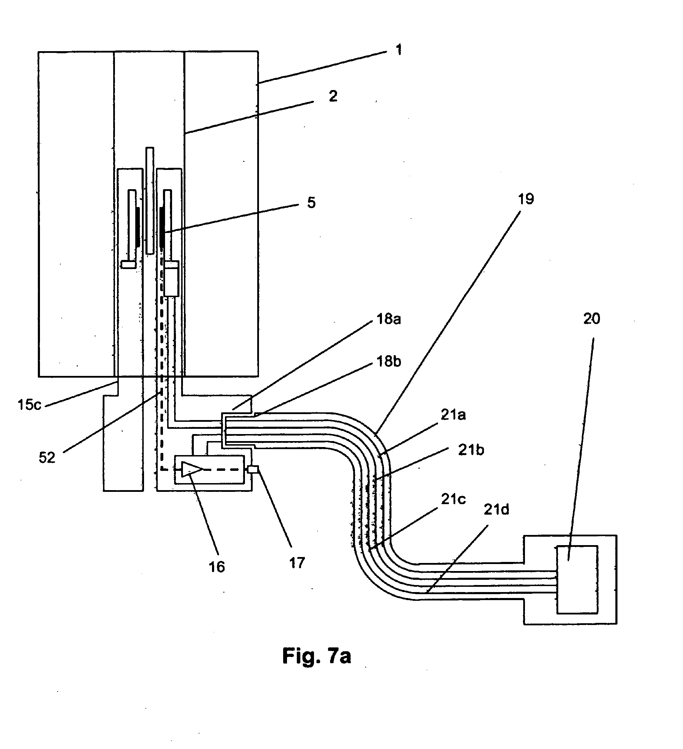

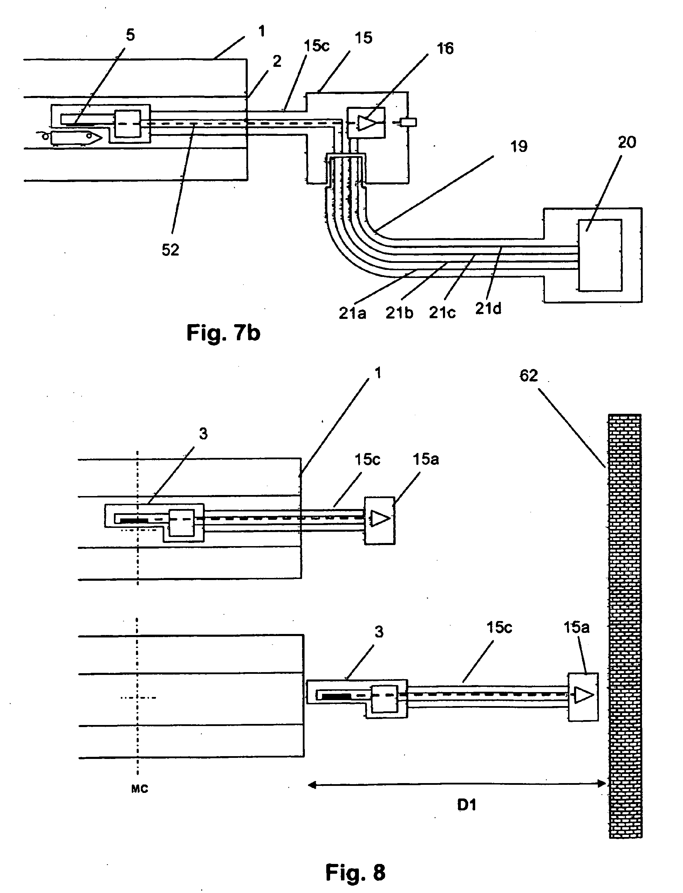

Die bisher bekannten gekühlten Systeme zur NMR-Detektion können in die folgenden Kategorien eingeteilt werden:
a) Direkt mit LN2 gekühlte Systeme. Dabei wird das LN2 in ein Gefäß eingeführt und die Messung solange durchgeführt, bis das Kühlmittel aufgebraucht (verdampft) ist. Eine solche Anordnung wird. z.B. in [1] aufgeführt, und ist hier in **Fig. 5** schematisch dargestellt.
b) Mit einem Kühlkopf in der unmittelbaren Nähe der Empfangsspule gekühlte Systeme. Dabei wird in der Regel ein so genannter Pulsrohr-Kühlkopf verwendet. Dieser ist kompatibel mit den Magnetfeld -und Vibrationsanforderungen. Eine solche Anordnung ist in [2] offenbart und ist hier in **Fig. 6** schematisch dargestellt.
c) Mit einem Kühlkopf gekühlte Systeme, wobei sich der Kühlkopf in einer gewissen Entfernung vom Probenkopf selbst befindet. Bei diesem Kühlkopf handelt es sich typischerweise um einen Gifford-McMahon Kühler, es kann aber auch ein Pulsrohr-Kühler vorgesehen sein. Der Probenkopf wird in der Regel mit einer flexiblen Transferleitung gekühlt, um die Entfernung zum Kryokühler zu überbrücken und um auch Vibrationen vom Probenkopf fernzuhalten. In dieser Transferleitung zirkuliert ein Wärmetransportmedium, typischerweise kaltes, gasförmiges Helium. Der Probenkopf selbst beinhaltet typischerweise die Empfangsspulen und den Vorverstärker, welche mit HF-Leitungen miteinander verbunden sind. Der Probenkopf ist dabei als eine starre Einheit ausgeführt. Eine solche Anordnung ist in [3] offenbart und in **Fig. 7b** (horizontaler Magnet) bzw. in **Fig. 7a** (vertikaler Magnet) dargestellt.

Es ist zu bemerken, dass hier nur vom Empfang der NMR-Signale die Rede ist. Dieser Vorgang ist auch derjenige, der zur Erreichung des bestmöglichen S/N-Verhältnisses sehr genau kontrolliert werden muss und kritisch von den Dämpfungen, Temperaturen und Rauschen der beteiligten Elemente abhängt.

Die Kerne müssen vor der Messung durch mindestens einen HF-Puls angeregt werden. Dies kann entweder durch die Empfangsspule selbst geschehen, oder aber durch eine separate Sendespule. Die Sendespule kann entweder auch gekühlt sein, oder aber sich auf Raumtemperatur befinden. Weitere Systeme und Vorrichtungen zur Erzeugung der Kernanregung werden hier der Einfachheit halber nicht diskutiert.

Nachfolgend werden die oben genannten MR-Probenköpfe gemäß dem Stand der Technik diskutiert:
**a)** Die Anordnungen gemäß a) **(****Fig. 5****)** sind relativ einfacher Bauart, und haben die Nachteile, dass flüssiger Stickstoff **60** in einem thermisch isolierten Gehäuse **61** nachgefüllt werden muss und die Temperatur der Empfangsspule **5** nur auf 77 K herunterkommt. Ein wichtiger Punkt ist dabei, dass sich normalerweise sowohl der Vorverstärker **58** wie auch die HF-Leitung **59** (normalerweise als Koaxialkabel ausgeführt) zwischen der Empfangsspule **5** und dem Vorverstärker 58 ebenfalls auf Raumtemperatur befinden. Dies hat zur Folge, dass einerseits der Vorverstärker 58 unnötig stark rauscht, und andererseits auch die HF-Leitung 59 eine zusätzliche Verschlechterung des S/N-Verhältnisses erzeugt. Dies hat folgende Gründe: Erstens wird das NMR-Signal selbst durch die Dämpfung der HF-Leitung 59 geschwächt. Zweitens erzeugt die HF-Leitung 59, als Folge ihrer Dissipation, auch selbst ein unerwünschtes Rauschsignal. Dieses ist umso stärker, je höher die Dämpfung der HF-Leitung 59, und je höher ihre physikalische Temperatur ist. Diese nachteiligen Effekte sind multiplikativ. Eine sich auf Raumtemperatur befindliche HF-Leitung 59 hat also folgende Nachteile: Ihre Signalverluste sind hoch, und zudem ist ihre physikalische Temperatur ebenfalls hoch, was zu einer in zweifacher Hinsicht hohen Rauschemission führt. Dadurch werden die oben aufgeführten Effekte hoch sein.
**b)** Die Anordnung gemäß b) **(****Fig. 6****)** ist was die Kühlung betrifft, potentiell eine bessere Lösung. Dabei kann das System sehr kompakt ausfallen, wobei die Kühlung in der Nähe der Empfangsspule **5** stattfindet, was das Erreichen einer tiefen Temperatur erleichtert. Das System ist auch ein geschlossenes System, das nur elektrische Energie zum Antrieb eines Kompressors **56** benötigt, der für den Betrieb eines Pulsrohr-Kühlkopfs **54** in einem thermisch isolierten Gehäuse **55** nötig und durch eine flexible Druckleitung **57** mit dem Pulsrohr-Kühlkopfs 54 verbunden ist. Es müssen insbesondere keine kryogenen Flüssigkeiten nachgefüllt werden.
   Die Anordnung hat aber einen schwerwiegenden Nachteil: Der Vorverstärker **58** muss hier entweder bei Raumtemperatur und/oder außerhalb des Magneten 1 betrieben werden. Im ersteren Fall ist seine Rauschtemperatur nicht optimal, sie ist viel zu hoch. Im letzteren Fall könnte der Vorverstärker 58 ebenfalls gekühlt werden. Es sind jedoch keine befriedigend funktionierenden Vorverstärker bekannt, die bei kalten Temperaturen (<< 77K) in den für die NMR, insbesondere Hochfeld- NMR verwendeten Magnetfeldern (>> 1T) einwandfrei funktionieren.
   Befindet sich der Vorverstärker 58 nun außerhalb des Magneten 1, so wird dieser nach dem Stand der Technik mit einer entsprechend langen HF-Leitung **59** mit der Empfangsspule 5 verbunden. Diese HF-Leitung 59 befindet sich auf Raumtemperatur und ist mit den unter b) oben erwähnten Nachteilen behaftet. Daraus ergibt sich eine unerwünschten Verschlechterung des S/N-Verhältnisses.
   Es stellt sich aber auch noch ein anderes Problem: Möchte man den Vorverstärker 58 kühlen, so muss er entweder durch LN2 gekühlt werden, was nicht besonders bedienungsfreundlich ist und der ursprünglichen ldee eines geschlossenen Systems entgegensteht. Die andere Möglichkeit wäre ein zweiter Pulsrohr-Kühlkopf, nur für den Vorverstärker 58. Dies ist aber mit einem großen Aufwand verbunden. Das Problem der ungekühlten HF-Leitung 59 würde auf jeden Fall weiter bestehen bleiben.
c) Die Anordnung gemäß c) **(****Fig. 7a****,** **Fig. 7b****)** ist technisch die beste der bekannten Anordnungen, und ermöglicht die potentiell höchste Performance, denn die HF-Empfangsspule 5 wird in der Raumtemperaturbohrung 2 des Magneten 1 bei einer sehr tiefen Temperatur (z.B. 20K), und der Vorverstärker **16** bei einer so tiefen Temperatur betrieben, dass er noch einwandfrei funktioniert (z.B. 77K). Auch die HF-Leitung **52** zwischen der Empfangspule 5 und dem Vorverstärker 16 befindet sich auf einer tiefen Temperatur. Die Temperatur geht dann typischerweise entlang der HF-Leitung 52 von 20 K auf 77 K über, wobei hier die Geometrie (Insbesondere der Querschnitt der Kabel der HF-Leitung 52) so gewählt wird, dass ein Optimum zwischen der Minimierung der HF-Leitungsverluste auf der einen Seite und der Minimierung des Wärmeeintrags in die kalte Empfangsspule 5, der sich durch die Wärmeleitfähigkeit der HF-Leitung 52 ergibt, andererseits, erzielt wird. Somit ist das S/N-Verhältnis des Systems praktisch optimal. Nach der Verstärkung mit dem gekühlten Vorverstärker **16** wird das Signal schlussendlich an einen Signalausgang **17** am Ausgang des Vorverstärkers 16 zur weiteren Signalverarbeitung ausgegeben. Die gesamte Kühlung kann mit einem einzigen Kryokühler **20** (Gifford-McMahon oder auch Pulsrohr-Kühlkopf) stattfinden.

Diese Anordnung ist bei den Hochauflösungsköpfen für NMR Spektroskopie seit einiger Zeit Stand der Technik **(****Fig. 7a****)** [3]. Es wurden nun nach diesem Prinzip auch Prototypen für MRI Bildgebung gebaut **(****Fig. 7b****)** [4]. Diese Anordnung hat jedoch den schwerwiegenden Nachteil, dass der gesamte Probenkopf lang ist, und sich dadurch die folgenden Probleme ergeben:
1. Die Installation kann bei ungünstigen räumlichen Verhältnissen unmöglich werden. Diese Problematik ist in **Fig. 8** dargestellt. Es muss ein ausreichend großer Abstand **D1** zwischen dem Magnet **1** und der Wand **62** vorhanden sein, sonst lässt sich das System gar nicht in den Magneten ein- bzw. wieder ausbauen. Dieser minimale Abstand ist im Wesentlichen durch die Summe der Längen der eigentlichen Detektionsvorrichtung **3,** des Vorverstärkergehäuses **15a** sowie der starren Verbindungseinrichtung **15c** gegeben.
2. Der gesamte Probenkopf ist mit seinem typischerweise großen Vorverstärker **16** sowie dem zugehörigen Gehäuse **15a** recht schwer, und ein Ein-/Ausbau erfordert typischerweise zwei Personen.
3. Durch das hohe Gewicht und die Sperrigkeit vom Probenkopf wie auch von der angeschlossenen Kühlleitung ist es sehr mühsam und unpraktikabel, einen solchen Probenkopf im kalten Zustand ein- bzw. auszubauen. Die Transferleitung **19 (****Fig. 7a**, **7b**), die zwischen dem Kryokühler **20** und dem Probenkopf verläuft, beinhaltet typischerweise vier gekühlte Druckleitungen (weiterführende Kühlleitungen **21a-21d),** und ist ziemlich schwer und unflexibel. Der kalte Ein-/Ausbau wäre aber wünschenswert und würde es ermöglichen, vor einem geplanten Einsatz des Probenkopfs diesen außerhalb der Raumtemperaturbohrung des Magneten abzukühlen, und erst unmittelbar vor der Messung in die Raumtemperaturbohrung einzuführen. Nach erfolgter Messung könnte dann der Probenkopf im noch kalten Zustand wieder herausgenommen werden, und entweder bis zum nächsten Einsatz kalt gelassen, oder draußen aufgewärmt werden. Dies ist jedoch aus den oben aufgeführten Gründen nicht praktikabel und so muss der Probenkopf typischerweise warm (d.h. bei Raumtemperatur) in die Raumtemperaturbohrung **2** eingeführt, dann an die Transferleitung **19** zum Kryokühler **20** angeschlossen werden. Erst dann kann mit dem Abkühlvorgang begonnen werden. Dies dauert typischerweise mindestens vier Stunden. Während dieser Zeit ist der Magnet 1 unproduktiv blockiert. Ähnlich verhält es sich beim Ausbau, die Aufwärmphase dauert typischerweise mindestens zwei Stunden. Dies sind Zeiten, die in Anbetracht der nötigen Auslastung eines MRI Systems nicht tragbar sind.

Nach dem Stand der Technik sind also entweder relativ kompakte gekühlte Systeme möglich, die jedoch eine nicht optimale Performance aufweisen. Auf der anderen Seite gibt es hochleistungsfähige Systeme mit optimal niedrigem Rauschen. Diese können jedoch bei beengten Verhältnissen für den Einbau grundsätzlich ungeeignet, oder aber in der Handhabung sehr inpraktikabel sein.

Aufgabe der vorliegenden Erfindung ist es daher, einen gut handhabbaren MR-Probenkopf vorzuschlagen, der eine hohe Empfindlichkeit aufweist, wobei ein schneller Ein- und Ausbau sowie eine rasche Inbetriebnahme der Detektionsvorrichtung ermöglicht werden.

Diese Aufgabe wird erfindungsgemäß dadurch gelöst, dass die Verbindungseinrichtung als eine mechanisch flexible Verbindungsleitung mit mechanisch flexiblen HF- und Kühlleitungen ausgeführt ist.

Die Detektionsvorrichtung des erfindungsgemäßen MR-Probenkopfs ist zum einen klein und leicht, da die Detektionsvorrichtung von einem externen Kühlvorrichtung gekühlt wird und daher weder einen Kaltkopf noch einen Kühlmittel-Vorratsgefäß enthält, zum anderen wird der Platzbedarf für den Ein- und Ausbau des MR-Probenkopfs durch die flexible Ausführung der Verbindungseinrichtung als auch der HF- und Kühlleitungen minimiert. Die Detektionsvorrichtung, die den Teil des Probenkopfes bildet, in unmittelbarer Nähe des zu untersuchenden Objekts arbeitet und für den Empfang der HF-Signale zuständig ist, kann somit rasch in den Magneten eingebaut und in Betrieb genommen werden kann. Ebenso kann nach Abschluss der Messungen die Detektionsvorrichtung schnell und einfach außer Betrieb gesetzt und aus der Raumtemperaturbohrung des Magneten entfernt werden.

Vorzugsweise handelt es sich bei dem erfindungsgemäßen MR-Probenkopf um einen Probenkopf für Magnetresonanz-Bildgebung(=MRI)-Anwendungen oder für NMR(Kernspinresonanz)-Spektroskopie. Insbesondere bei MRI-Anwendungen ist eine rasche Handhabung besonders vorteilhaft, da ein häufiger Wechsel der Untersuchungsmethoden und somit der Detektionsvorrichtung notwendig ist. Mittels des erfindungsgemäßen MR-Probenkopfs können unproduktiven Stillstandzeiten des sehr teueren Magnetsystems reduziert werden.

Statt den MR-Probenkopf mittels einer einzigen Kühlleitung zu kühlen, wobei das Kühlmittel an den zu kühlenden Komponenten verdampft, ist es bei dem erfindungsgemäßen MR-Probenkopf besonders vorteilhaft, wenn zwei Kühlleitungen vorgesehen sind, die Teil eines ersten Kühlkreislaufs sind. Hierbei besteht die Möglichkeit das Kühlmittel rückzukühlen oder auch gegebenenfalls rückzuverflüssigen und wieder zu verwenden.

Eine besonders bevorzugte Ausführungsform der Erfindung sieht vor, dass jeweils eine oder mehrere HF-Leitungen einer einzelnen Kühlleitung zugeteilt sind und dort zusammen mit der zugeteilten Kühlleitung jeweils ein Leitungspaket bilden.

Innerhalb eines Leitungspakets sind die Leitungen dicht beieinander angeordnet, so dass zwischen den einzelnen Leitungen innerhalb des Leitungspaketes ein Temperaturausgleich stattfinden kann.

Bei einer Weiterbildung dieser Ausführungsform sind die Kühlleitung und die der Kühlleitung zugeteilten HF-Leitungen eines einzelnen Leitungspaketes in, vorzugsweise regelmäßigen, Abständen über thermisch gut leitende Ankopplungselemente miteinander thermisch verbunden. Diese Ankopplungselemente können beispielsweise aus Kupfer gefertigt sein.

Eine weitere Weiterbildung sieht vor, dass zumindest eines der Leitungspakete mindestens ein elastisches Verstärkungselement, insbesondere einen Draht hoher mechanischer Festigkeit, enthält, wodurch eine Reduktion der mechanischen Zug- und Biegebeanspruchung der HF- und Kühlleitungen erreicht wird. Das Verstärkungselement kann z.B. aus Edelstahl sein.

Bei einer bevorzugten Ausführungsform sind die Leitungspakete gegeneinander über die gesamte Länge der Verbindungsleitung, vorzugsweise mindestens einmal, um die Achse der Verbindungsleitung verdreht.

Besonders vorteilhaft ist es, wenn innerhalb der Leitungspakete die HF-Leitungen und/oder die elastischen Verstärkungselemente zwischen zwei Ankopplungselementen um im Wesentlichen 360 Grad oder ein ganzzahliges Vielfaches davon mit der Kühlleitung verdrillt, insbesondere um die Kühlleitung herum gewickelt angebracht sind. Hierdurch wird erreicht, dass die Gesamtlänge aller Leitungen zwischen den Ankopplungselementen bei einer Biegung weitgehend gleich bleibt. Dies hat zur Folge, dass beim Biegen der Verbindungsleitung keinerlei Beulen oder Knicken in den Leitungen auftritt. Es ist auch denkbar, dass die Kühlleitung um die HF-Leitungen und/oder die elastischen Verstärkungselemente, oder auch beide zusammen verdrillt sind. Auch kann die Kühlleitung um die HF-Leitung herum vorverdrillt angeordnet sein.

Die HF-Leitung des erfindungsgemäßen MR-Probenkopfs umfasst vorteilhafterweise ein flexibles Koaxialkabel mit vorzugsweise Polytetrafluorethylen (PTFE) Isolation, bei dem der Außenleiter aus einer Kombination von einem Metallgeflecht und einer spiralförmig gewickelten, elektrisch gut leitenden Metallfolie besteht.

Besonders vorteilhaft ist es, wenn die kalten Teile der Verbindungsleitung, insbesondere die Kühlleitungen sowie die HF-Leitungen, zur thermischen Isolation in einem Vakuum innerhalb mindestens eines flexiblen Außenmantels angeordnet sind. Auf diese Weise, insbesondere durch Superisolation, wird der Wärmeeintrag in die kalten Teile des MR-Probenkopfs minimiert. Die Verbindungsleitung kann auch zwei parallel geführte Schlauchleitungen als Außenmantel umfassen, wobei eine Schlauchleitung die Vor- und der andere die Rückleitung, mit je einer Anzahl zugeordneter HF-Leitungen beherbergt. Diese Anordnung hat den Vorteil, dass die beiden Schlauchleitungen je einen kleineren Durchmesser haben können, und somit flexibler gestaltet werden können. Eine Ausführungsform mit einem einzigen Außenmantel hingegen hat den Vorteil einer besserer thermischen Isolation aufgrund einer kleineren Gesamtoberfläche für einen gegebenen Querschnitt sowie einer (von außen) einfacheren, robusteren und sauberer aussehenden Anordnung, wie auch eines isotropes Biegeverhalten.

Die Elektronik des gekühlten Vorverstärkers wird vorzugsweise durch einen, von der mindestens einen Kühlleitung separaten, zweiten Kühlkreislauf gekühlt.

Bei einer besonders bevorzugten Ausführungsform werden der erste und der zweite Kühlkreislauf von derselben Kühlvorrichtung gekühlt, so dass sowohl die Kosten als auch der Platz für eine weitere Kühlvorrichtung eingespart werden kann.

Für die Kühlung der Komponenten des MR-Probenkopfs ist vorzugsweise Helium als Kühlfluid vorgesehen.

Es kann vorteilhaft sein, wenn die Kühlvorrichtung ein Gifford-Mc Mahon Kühler ist.

Alternativ dazu kann die Kühlvorrichtung ein Pulsrohrkühler sein.

Vorzugsweise wird das Antennensystem bei einer tieferen Temperatur betrieben als der Vorverstärker.

Bei einer Weiterbildung dieser Ausführungsform werden das Antennensystem bei einer Temperatur im Bereich von 4 - 40 K und der Vorverstärker bei einer Temperatur im Bereich von 40 - 100 K betrieben.

Bei einer besonders bevorzugten Ausführungsform des erfindungsgemäßen MR-Probenkopfs ist der Abstand zwischen dem Vorverstärker und dem vorverstärkerseitig letzten Ankopplungselement größer ist als der durchschnittliche Abstand zweier Ankopplungselemente. Zwischen der HF-Leitung und der Kühlleitung wird also auf der Strecke zwischen dem Vorverstärker und dem vorverstärkerseitig letzten Ankopplungselement kein Wärmekontakt ausgeführt, so dass die Temperatur der HF-Leitungen im Wesentlichen der Temperatur der Kühlleitungen bzw. ungefähr der Temperatur T_{c} der Empfangsspulen entspricht, und nur kurz vor dem Vorverstärker der Temperaturübergang zur Vorverstärkertemperatur **T**_{P} stattfindet. Während also in einem großen Bereich entlang der HF-Leitung diese durch eine ausreichend dichte (eng benachbarte) Anordnung von Ankopplungselementen gekühlt wird, wird für den Temperaturübergang zum Vorverstärker diese Ankopplung auf der oben beschriebenen Strecke nicht mehr ausgeführt, so dass die Temperatur dann stetig steigen kann.

Bezüglich der Handhabbarkeit ist es von Vorteil, wenn die Masse der Teile der Detektionsvorrichtung weniger als 5kg beträgt.

Eine besonders bevorzugte Ausführungsform des erfindungsgemäßen MR-Probenkopfs sieht vor, dass der Vorverstärker mehrere parallele Vorverstärkerkanäle umfasst.

Dabei kann es vorteilhaft sein, wenn der Vorverstärker mehrere, insbesondere 2, 3, 4, 6, 8, 12, oder 16 parallele Kanäle für den gleichen zu untersuchenden Kern, insbesondere 1 H, umfasst.

Eine weitere Ausführungsform der Erfindung sieht vor, dass der Vorverstärker Kanäle für die Verstärkung der Signale der Kerne 31 P, 13C, 23Na, 19F, 170, 129Xe oder 2H umfasst.

In den Rahmen der Erfindung fällt auch ein MR-System mit einem zuvor beschriebenen erfindungsgemäßen Probenkopf.

Die Vorteile der Erfindung kommen besonders gut zu Geltung wenn das MR-System ein MRI- oder ein NMR-System ist.

Bei dem erfindungsgemäßen MR-Probenkopf kann die Verbindungsleitung mitsamt ihren inneren Bestandteilen so flexibel ausgestaltet werden, dass der in der Verlängerung der Raumtemperaturbohrung für den Ein- und Ausbau der Detektionsvorrichtung benötigte Raum geringer ist als der Abstand vom Magnetzentrum bis zum Ende des Magneten. Darüber hinaus ermöglicht der erfindungsgemäße MR-Probenkopf insbesondere durch die erfindungsgemäße Gestaltung der Verbindungsleitung, dass der Ein- und Ausbau der Detektionsvorrichtung auch in kaltem Zustand möglich ist. Auf diese Weise können MR-Systeme mit höchster Leistungsfähigkeit, insbesondere in Bezug auf das Signal/Rausch(S/N)-Verhältnis, und einfacher Handhabbarkeit realisiert werden.

Weitere Vorteile der Erfindung ergeben sich aus der Beschreibung und der Zeichnung. Ebenso können die vorstehend genannten und die weiter aufgeführten Merkmale je für sich oder zu mehreren in beliebigen Kombinationen Verwendung finden. Die gezeigten und beschriebenen Ausführungsformen sind nicht als abschließende Aufzählung zu verstehen, sondern haben vielmehr beispielhaften Charakter für die Schilderung der Erfindung.

Es zeigen:
- Fig. 1: einen erfindungsgemäßen MR-Probenkopf in Betriebsposition und während des Ein-/Ausbaus in/aus den Magneten;
- Fig. 2: eine schematische Darstellung eines erfindungsgemäßen MR-Probenkopfs;
- Fig. 3a: eine detaillierte Darstellung eines erfindungsgemäßen MR-Probenkopfs;
- Fig. 3b: eine Detailansicht eines Leitungspakets eines erfindungsgemäßen MR-Probenkopfs mit Ankopplungselementen;
- Fig. 3c: eine Detailansicht eines Leitungspakets eines erfindungsgemäßen MR-Probenkopfs mit Verstärkungselementen;
- Fig. 4a: einen Temperaturverlauf einer HF-Leitung eines erfindungsgemäßen MR-Probenkopfs in Abhängigkeit ihrer laufenden Länge;
- Fig. 4b: einen Aufbau eines HF-Kabels für eine HF-Leitung eines erfindungsgemäßen MR-Probenkopfs;
- Fig. 5: einen MR-Probenkopf nach dem Stand der Technik mit LN2-Kühlung der Empfangsspule;
- Fig. 6: einen MR-Probenkopf nach dem Stand der Technik in einem Horizontalmagneten mit einem Pulsrohr-Kühler in der Raumtemperaturbohrung des Magneten zur Kühlung einer Empfangsspule;
- Fig. 7a: einen NMR-Probenkopf mit einer starren Verbindungseinrichtung nach dem Stand der Technik in einem Vertikalmagneten für hochauflösende NMR-Spektroskopie;
- Fig. 7b: einen MRI-Probenkopf mit einer starren Verbindungseinrichtung nach dem Stand der Technik in einem Horizontalmagneten für MRI Anwendungen; und
- Fig. 8: einen MR-Probenkopf entsprechend Fig. 7b in Betriebsposition und während des Ein-/Ausbaus in/aus den Magneten;
- Fig. 9a: einen erfindungsgemäßen NMR-Probenkopf mit flexibler Verbindungsleitung in einem Vertikalmagneten für hochauflösende NMR-Spektroskopie; und
- Fig. 9b: einen erfindungsgemäßen MRl-Probenkopf mit flexibler Verbindungsleitung in einem Horizontalmagneten für MRI-Anwendungen.

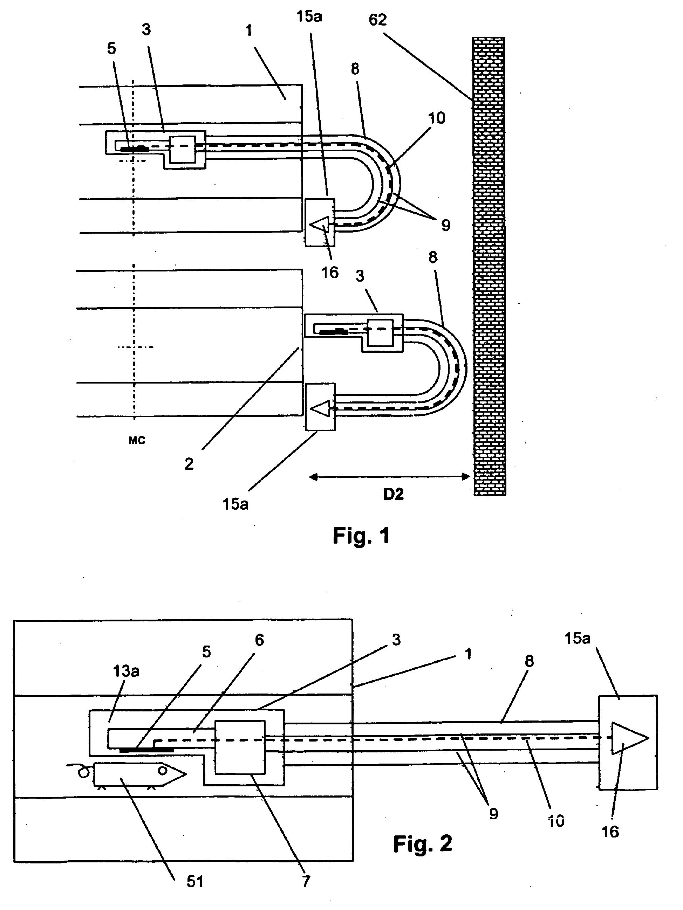

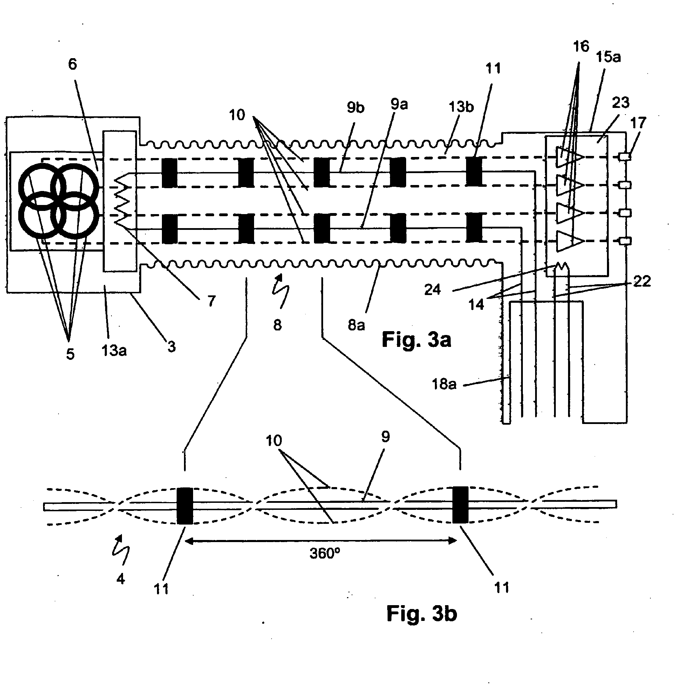

Der erfindungsgemäße Probenkopf zum Empfang von NMR-Signalen ist schematisch in **Fig. 1** gezeigt und umfasst folgende Komponenten:
a) eine Detektionsvorrichtung **3** mit mindestens einem kryogen gekühlten Antennensystem. Das Antennensystem des erfindungsgemäßen MR-Probenkopfs umfasst mindestens eine Antenne, wobei eine solche Antenne aus mindestens einer Empfangsspule **5,** oder einem Resonator, oder einer anderen Art eines für elektromagnetische Felder empfindlichen HF-Schwingkreises bestehen kann. Bei den hier behandelten Detektionsvorrichtungen geht es insbesondere um MRI Systeme für die Untersuchung, insbesondere die Abbildung von Objekten, und insbesondere von Lebewesen. Die erfindungsgemäße Vorrichtung kann aber auch für Systeme für die NMR Spektroskopie oder auch für kombinierte Methoden wie z.B. die lokalisierte Spektroskopie gebraucht werden.
b) einen gekühlten Vorverstärker **16** in einem Vorverstärkergehäuse **15a,** das örtlich getrennt von der NMR-Detektionsvorrichtung 3 angeordnet ist,
c) eine von der Umgebung thermisch isolierte, flexible Verbindungsleitung 8, mit der die NMR-Detektionsvorrichtung 3 und das Vorverstärkergehäuse 15a miteinander verbunden sind, wobei die flexible Verbindungsleitung 8 sowohl Kühlleitungen **9** (siehe Fig. 3a, 3b) für die Zu- beziehungsweise Rückleitung eines Kühl-Fluidums, wie auch HF-Leitungen **10** zur Übertragung der elektrischen Signale umfasst.

Dank der Flexibilität der Verbindungsleitung 8 wird erreicht, dass der von außen benötigte freie Abstand **D2** von beispielsweise einer Wand **62** zum Ausgang der Raumtemperaturbohrung 2 des Magneten 1, der vorhanden sein muss, um die NMR-Detektionsvorrichtung in die Raumtemperaturbohrung des NMR-Magneten hinein und wieder herauszuführen, möglichst klein ist.

Der dadurch entstehende Vorteil macht sich besonders stark bei horizontalen MRI-Magneten bemerkbar, die aus Platzgründen z.B. nahe an der Wand 62 aufgestellt sind.

Fig. 1 zeigt den erfindungsgemäßen MR-Probenkopf in einem Horizontalmagneten, bei dem sowohl die Empfangsspule 5 wie auch der Vorverstärker 16 auf die tiefstmögliche Temperatur abgekühlt sind, und ihre HF-Leitung 10 ebenfalls auf einer sehr tiefen Temperatur gehalten wird. Das System löst die Erfindungsaufgabe durch die flexible Ausführung der Verbindungsleitung 8 mit einer gekühlten flexiblen HF-Leitung 10 zwischen der Empfangsspule 5 und dem Vorverstärker 16. Dies ermöglicht unter Beibehaltung aller Performance-Vorteile eine sehr gute Handhabung, denn die Detektionsvorrichtung 3, also das Ende des Probenkopfes, welche die Empfangsspule(n) 5 beinhaltet, ist klein, leicht, und lässt sich dank der erfindungsgemäßen hochflexiblen Verbindungsleitung 8 sehr gut handhaben. (Die kompakte Größe und geringes Gewicht werden möglich, da die Detektionsvorrichtung 3 im Gegensatz zum Stand der Technik gemäß a) oder b) weder einen Kaltkopf noch ein Kühlmittel-Vorratsgefäß enthalten muss). Insbesondere lässt sich das System bei einer entsprechenden Ausführung, die weiter unten näher erläutert wird, auch jederzeit in kaltem Zustand in den Magneten 1 ein- wie auch ausführen. Somit sind alle Nachteile der Variante c) eliminiert, und die Vorteile dieser Variante bleiben praktisch ungeschmälert. Die erfindungsgemäße Vorrichtung vereint daher alle Vorteile der bestehenden Systeme, ohne aber deren Nachteile aufzuweisen.

Die Realisation der erfindungsgemäßen Anordnung wurde bisher nicht in Betracht gezogen, da sie technologisch sehr hohe Anforderungen stellt. Sie ist schematisch in **Fig. 2** und im Detail in **Fig. 3a** gezeigt. In beiden Figuren ist der Probenkopf in gestreckter Position dargestellt. Dabei sind folgende technische Anforderungen an das System und die Verbindungsleitung 8 gleichzeitig erfüllt:
1. Die Verbindungsleitung 8 weist einen flexiblen Außenmantel auf, in dem die Kühl- und HF-Leitungen verlaufen und durch ein Vakuum von der Umgebung isoliert sind, der sich bei Evakuierung möglichst wenig zusammenzieht.
2. Die Kühlleitung 9 (für einen ersten Kühlkreislauf **14** sind mindestens zwei Kühlleitungen **9a, 9b** notwendig) für die Spulenkühlung ist flexibel. Diese müssen einen Druck von der Größenordnung 20 - 30 bar aushalten und dabei flexibel bleiben. In einer bevorzugten Ausführungsform sind sie auch noch kalt biegbar. Der gewünschte Biegeradius bewegt sich in der Größenordnung von 30 cm, was sehr wenig ist. Die Kühlleitungen 9, 9a, 9b müssen gegen Ermüdung durch wiederholte Handhabung genügend resistent sein und somit genügend Biegezyklen aushalten.
3. Die HF-Leitungen 10 (mindestens eine, vorzugsweise aber vier oder mehr) sind, vorzugsweise auch in kaltem Zustand, flexibel und weisen niedrige HF-Verluste auf. Sie dürfen auch nach vielen Zyklen keine Ermüdungsbrüche zeigen und nur ein geringes Übersprechen der Signale gegeneinander haben. Um die HF-Verluste und das Rauschen niedrig zu halten, müssen die HF-Leitungen 10 bei einer möglichst tiefen Temperatur betrieben werden können.
4. Die Verbindungsleitung 8 und das Antennensystem weisen eine sehr gute thermische Isolation auf.

Fig. 2 zeigt die schematische Darstellung vom Magneten 1 mit einem Messobjekt **51** und der eingebauten Detektionsvorrichtung 3 des Probenkopfes, in der sich ein Vakuum **13a** befindet. Dabei ist hier die flexible Verbindungsleitung 8 in einer gestreckten Position dargestellt. Auf der linken Seite ist die Detektionsvorrichtung 3 mit einem zu dem Vakuum 13a in der Detektionsvorrichtung 3 isolierten, vakuumdichten Gehäuse gezeigt. Dieses beinhaltet das Antennensystem in der Form von vier Empfangsspulen 5 sowie einen Wärmetauscher **7,** sowie eine wärmeleitende Verbindung **6** zwischen dem Wärmetauscher 7 und den Empfangsspulen 5 zum Kühlen der Empfangsspulen 5. Prinzipiell können auch mehrere Wärmetauscher 7 vorgesehen sein In der Mitte ist die flexible Verbindungsleitung 8 dargestellt. Rechts sieht man das Vorverstärkergehäuse 15a, mit dem gekühlten Vorverstärker 16 (ohne weitere Details). Die flexible HF-Leitung 10 ist hier, wie auch in allen anderen Figuren, durch eine gestrichelte Linie dargestellt.

In **Fig. 3a** ist das System detaillierter dargestellt. Die Verbindungsleitung 8 umfasst den vakuumdichten Außenmantel, hier in Form eines Wellbalgs **8a,** zwei Kühlleitungen 9a und 9b, sowie die HF-Leitungen 10 und ist ebenfalls gestreckt dargestellt. Die Empfangsspulen 5 bilden hier ein 4-er Spulen-Array und werden durch den Wärmetauscher 7 gekühlt. Die am Wärmetauscher 7 angeschlossenen Kühlleitungen 9a, 9b führen durch die Verbindungsleitung 8 ins Vorverstärkergehäuse 15a. Obwohl es sich bei den Kühlleitungen 9a, 9b um Röhrchen bzw. dünne Wellbälge handelt, sind sie in dieser Darstellung wie auch in den anderen Figuren nur als ein Strich dargestellt. Sie gehen in ein vorverstärkerseitiges Kupplungsteil **18a** einer Kupplung, die das Vorverstärkergehäuse 15a mit einem Kryokühler **20** (in Fig. 3a nicht gezeigt) verbinden kann. Eine solche Kupplung ist z.B. in [5] und [3] offenbart. Die kalten Leitungen 9a, 9b, 10 innerhalb der Verbindungsleitung 8 werden mit einer Vakuumisolation **13b** wie auch optionalen zusätzlichen Superisolation (nicht dargestellt) thermisch isoliert.

Jede der in Fig. 3a gezeigten vier Empfangsspulen 5 ist mittels einer der erfindungsgemäßen flexiblen HF-Leitungen 10 mit einem der gekühlten Vorverstärker 16 verbunden. Die vier Vorverstärker 16 können in diesem Ausführungsbeispiel mit einer thermischen Stufe (Wärmesenke) **23** innerhalb eines zweiten Kühlkreislaufs **22** mit weiterführenden Kühlleitungen **21c, 21d** eines kryokühlerseitigen Kupplungsteils 18b, welches beispielsweise in Fig. 7a gezeigt und in [6] beschrieben ist, verbunden werden.

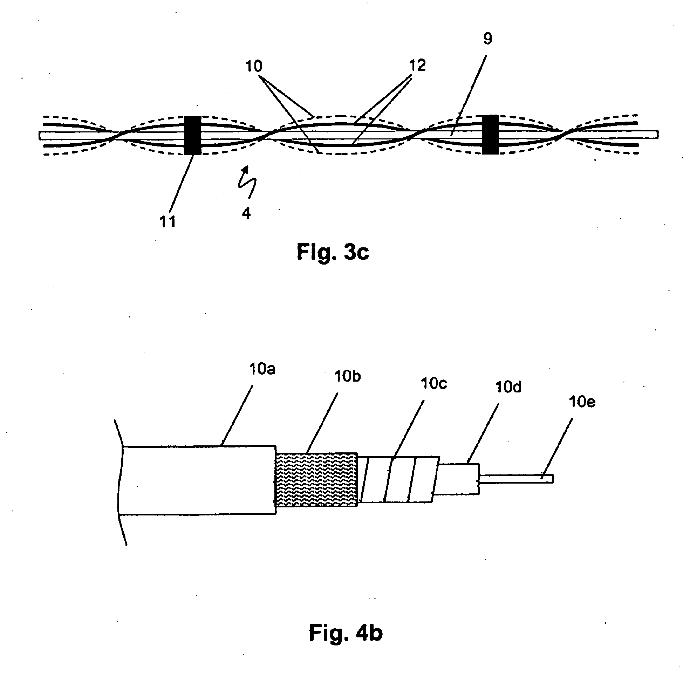

Die Temperatur der Empfangsspulen 5 beträgt z.B. 20K, die Temperatur des Vorverstärkers16 z.B. 77K. Eine besonders bevorzugt Ausführungsform der erfindungsgemäße Verbindungsleitung 8 hat die folgende, unten näher beschriebene Struktur:
- Der Außenmantel besteht aus dem Wellbalg 8a, der vorzugsweise mit einem Drahtgeflecht verstärkt ist. Dadurch wird eine gute Flexibilität gewährleistet, wobei jedoch die Kontraktion durch Evakuieren auf einem vertretbaren Stand gehalten wird.
- Kühlung: Die HF-Leitungen 10 werden von den Empfangsspulen 5 zum Vorverstärker 16 nicht direkt geführt, sondern werden entlang des Weges unter sehr gut definierten Bedingungen, die noch weiter unten erörtert werden, aktiv gekühlt. Für diese Kühlung wird mindestens eine der vorhandenen Kühlleitungen 9, die zu den Empfangsspulen 5 führen, verwendet. Jeder Kühlleitung 9a und/oder 9b kann dabei eine Anzahl flexibler HF-Leitungen 10 zugeordnet werden. Dabei spielt es keine wesentliche Rolle, welche der Kühlleitungen 9a, 9b verwendet wird. Der Vorlauf (Kühlleitung 9a) hat eine etwas tiefere Temperatur als der Rücklauf (Kühlleitung 9b). Im einfachsten Falle ist nur eine flexible HF-Leitung 10 z.B. an die Vorwärtsleitung 9a angebunden. In einem komplexeren Fall können z.B. mit dem Vorlauf 9a vier HF-Leitungen 10 gekühlt werden, ebenso vier mit dem Rücklauf 9b. Somit ergeben sich acht parallele, gekühlte HF-Leitungen.
- Die Leitungen 9a, 9b, 10 werden mittels Ankopplungselementen **11** thermisch aneinander gekoppelt. Ein solches Ankopplungselement 11 besteht typischerweise aus einem Cu-Zylinder, an dem die Kühlleitung 9a oder 9b, der Außenleiter 10b und/oder der innere Außenmantel 10c (Fig. 4b) der flexiblen HF-Leitung 10, sowie ggf. weitere Elemente mechanisch und thermisch verbunden werden, vorteilhafterweise durch Löten.
- Zwischen zwei Ankopplungselementen 11 werden die HF-Leitungen 10 vorzugsweise in einer definierten Weise periodisch verdreht **(****Fig. 3b****).** Dies wird noch weiter unten genauer erörtert.
- Die Kühlleitung 9 bzw. das Leitungspaket 4 wird zusätzlich durch geeignete Verstärkungselemente 12, z.B: Stahl-Drähte **(****Fig. 3c****)** versteift.
- Die Leitungen werden durch die Vakuumisolation 13b (Fig. 3a) und Superisolation thermisch gegenüber dem Außenmantel, der sich bei Raumtemperatur befindet, isoliert, und optional mit Spacern (nicht dargestellt) abgestützt.

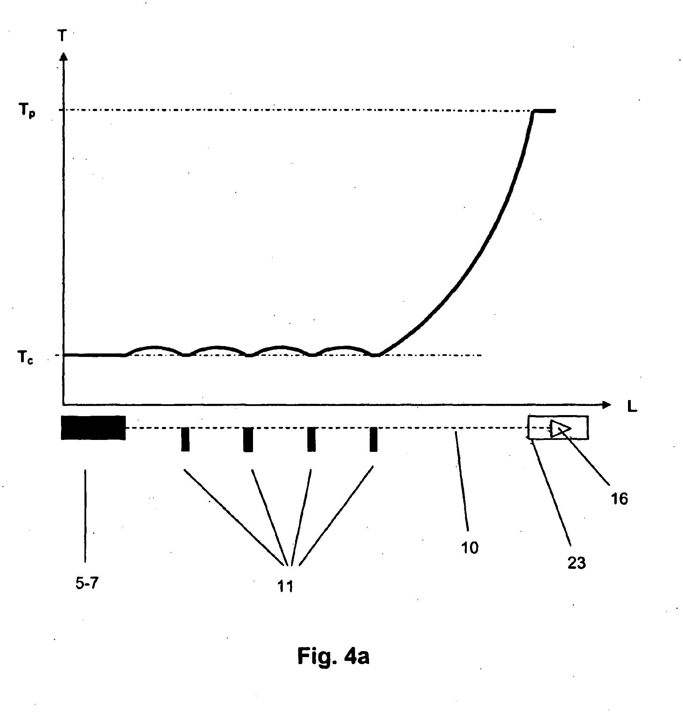

Der Temperaturverlauf einer der HF-Leitungen 10 ist in **Fig. 4a** dargestellt.

Die Temperatur der flexiblen HF-Leitungen 10 wird auf einer vorgegebenen Länge, die in der Praxis praktisch der gesamten Länge der Verbindungsleitung 8, ausgehend von den Empfangsspulen 5 und ggf. weiterer thermischer Elemente (wärmeleitende Verbindung 6, Wärmetauscher 7) (links im Bild als Blackbox), entspricht, auf einer sehr tiefen Temperatur gehalten. Diese Temperatur entspricht ungefähr der Temperatur T_{c} der Empfangsspulen 5, kann aber auch etwas darunter liegen, da die flexible HF-Leitung 10 direkt von der oder den Kühlleitungen 9a, 9b (Fig. 3a) gekühlt wird. Der Vorlauf 9a hat dabei stets eine tiefere Temperatur als die Empfangsspule 5. Die Kühlung der HF-Leitung 10 wird durch mehr oder weniger regelmäßige thermische Anbindung der HF-Leitung 10 durch die Ankopplungselemente 11 auf der gesamten Länge zwischen den Ankopplungselementen aufrechterhalten. Dabei bleibt die HF-Leitung 10 trotzdem hochflexibel. Die Abstände zwischen den Ankopplungselementen 11 können problemlos so dimensioniert werden, dass dank der ausreichenden thermischen Längs-Leitfähigkeit der HF-Leitung 10 und dem bei Verwendung einer guten Vakuumisolation 13b nur sehr geringen Wärmeeintrag von außen auch zwischen den Ankopplungselementen 11 die Temperatur nur in der Größenordnung von 1 K ansteigt. Der Temperaturverlauf der HF-Leitungen 10 zwischen den Ankopplungselementen 11 ist annähernd eine quadratische Funktion. Dadurch kann die maximale Temperaturüberhöhung im Bedarfsfall durch eine etwas engere Anordnung der Ankopplungselemente 11 problemlos reduziert werden.

Erst auf einer genau zu wählenden Strecke kurz vor dem Vorverstärker 16 bzw. seiner thermischen Stufe 23 (rechts in Fig. 4a) hören die thermischen Anbindungen mit den Ankopplungselementen 11 auf. Dann ergibt sich ein kontinuierlicher Übergang zwischen der Temperatur der Kühlleitung 9a, 9b und der Vorverstärkertemperatur **T**ₚ. Der genaue Verlauf hängt von der Wärmeleitfähigkeit der HF-Leitung 10 als Funktion der Temperatur sowie vom externen Wärmeeintrag ab und ist in Fig. 4a nur schematisch dargestellt. Die Länge der Strecke dieses Übergangs wird aber so dimensioniert, dass die totalen zusätzlichen HF-Verluste bzw. der Rauscheintrag des wärmeren Teils der HF-Leitung 10 so gering wie möglich werden, ohne aber eine zu hohe Wärmebrücke zwischen den Kühlleitungen 9a bzw. 9b und dem Vorverstärkern 16 zu bilden, denn je kürzer dieser Übergang wird, umso tiefer sind die totalen negativen Verlustauswirkungen, aber umso höher ist die Wärmeleitung entlang der Übergangsglänge. Eine zu hohe Wärmeleitung würde dazu führen, dass die Temperatur des ersten Kreislaufs, der u.A. die Kühlleitungen 9a, 9b umfasst, und somit schlussendlich auch die Temperatur der Empfangsspule(n) 5 unnötig erhöht werden. Bei einer optimalen Wahl kann die Länge der Strecke des Übergangs so gewählt werden, dass die Gesamtperfomance minimal beeinträchtigt wird. Diese Optimierung ist aber unkritisch, und vor allem nahezu unabhängig von der Länge **L** der HF-Leitung, da die Temperatur des sich zwischen den Ankopplungselementen 11 befindlichen gekühlten Leitungsteils stets minimal bleibt, und nur ein kurzer Teil der HF-Leitung 10 den Temperaturübergang bildet. Mit dieser thermischen Anordnung werden auch bei langen Verbindungsleitungen 8 extrem tiefe HF-Verluste erzielt, die nur mit sehr geringen Rauschzunahmen verbunden sind und somit die Leistungsfähigkeit des Systems nur unwesentlich beeinflussen.

Als HF-Leitung 10 selbst wird vorzugsweise eine besondere, im Folgenden beschriebene Ausführung verwendet: Die HF-Leitung 10 wird dabei als Koaxialkabel realisiert. Normal gebräuchliche Koaxialleiter sind einerseits entweder völlig starr ("rigid") oder halb starr ("semi-rigid"). Diese beiden Ausführungsformen sind jedoch für den erfindungsgemäßen MR-Probenkopf völlig ungeeignet, da sie bei den erforderlichen Biegeradien bereits nach wenigen Biegezyklen brechen würden. Auf der anderen Seite gibt es Koaxialkabel mit einem Drahtgeflecht als Außenmantel. Diese sind ausreichend flexibel. Sie haben jedoch prinzipbedingt wegen der Löcher im Schirmgeflecht den Nachteil, dass ihre Schirmwirkung nicht sehr gut ist, typischerweise nur ca. 40 dB. Dies ist nicht sehr günstig, da bei mehreren dicht beieinander verlaufenden Kabeln ein Übersprechen insbesondere bei einem Array-System die gegenseitige Entkopplung der Kanäle beeinträchtigt.

Ein vorteilhafter Bestandteil der erfindungsgemäßen Anordnung ist daher die Verwendung eines besonderen Koaxialkabels, das einen zusätzlichen inneren Außenmantel 10c aus einer spiralförmig gewickelten Metallfolie besitzt, der mit einem Außenleiter 10b in der Form von einem konventionellen Drahtgeflecht umgeben ist. Ein solches Kabel ist schematisch in **Fig. 4b** dargestellt. Solche Kabel haben für den Verwendungszweck die sehr günstige Eigenschaft, dass sie einerseits immer noch genügend flexibel sind und andererseits über sehr hohe Schirmwerte verfügen (> 90dB), und bei tiefen Temperaturen eine sehr gute HF-Güte und somit niedrige Verluste aufweisen. Sie können mit einem PTFE-Mantel 10a versehen werden, der genügend flexibel ist und auch bei kalten Temperaturen nicht reißt. Zusätzlich kann die Biegbarkeit des Mantels bei Bedarf durch Unterteilung in kurze Segmente weiter gesteigert werden, so dass die HF-Leitung auch in kaltem Zustand hochflexibel gehalten werden kann. Dieser PTFE-Mantel 10a hält das Koaxialkabel auch bei tiefen Temperaturen zuverlässig zusammen. Das Innere des Kabels ist durch einen konventionellen Isolator **10d,** insbesondere aus PTFE, ausgestaltet. Als Innenleiter **10e** kann entweder eine Litze oder aber ein Einzelleiter dienen.

Ein solches Kabel weist bei den kritischen äußeren Lagen 10a-10c eine hinreichende Flexibilität auf, und die Inneren Bestandteile 10d, 10e sind wegen der kleinen Durchmesser für die vorgesehenen Biegebelastungen nicht mehr kritisch. So wird erreicht, dass die HF-Leitung 10 alle für die vorgesehene Anwendung benötigten Eigenschaften besitzt: Sie ist flexibel, weist sehr tiefe Dämpfungswerte bei tiefen Temperaturen sowie eine gute Überprechdämpfung auf, und ist auch gegen Biege-Ermüdung hinreichend resistent.

Ein weiteres wesentliches Merkmal der erfindungsgemäßen Verbindungsleitung ist, dass die HF-Leitungen 10 nicht parallel zu ihren zugeordneten Kühlleitungen 9 geführt, sondern zwischen zwei Ankopplungselementen 11 um ungefähr 360 Grad oder ein ganzzahliges Vielfaches davon gegenüber der Kühlleitung 9 verdreht werden. Die Kühl- und HF-Leitungen bilden ein Leitungspaket **4.** Dies ist in **Fig. 3b** dargestellt. Dieses hat die Auswirkung, dass bei einer Biegung der Verbindungsleitung 8 die Gesamtlänge des Abschnitts der HF-Leitungen 10 zwischen zwei Ankopplungselementen 11 sowohl untereinander wie gegenüber der Kühlleitung 9 gleich bleibt, denn die Längenunterschiede der sich gegen das Biegezentrum hin gewandten und der sich außen befindenden Teile gleichen sich bei einer solchen Verdrillung in erster Ordnung stets aus. Dies hat zur Folge, dass beim Biegen der Verbindungsleitung 8 keinerlei Beulen oder Knicken der HF Leitungen 10 auftritt. Ohne diese Maßnahme wäre die Lebensdauer der HF-Leitungen 10 durch wiederholtes lokales Knicken in unvorhersehbarer Weise gefährdet, und auch die Kühlleitung 9 würde unnötigen lokalen Kräften ausgesetzt.

Schließlich besitzt die erfindungsgemäße Verbindungsleitung vorzugsweise noch ein weiteres Merkmal: Es können zwei oder mehr in definierter Weise steife bzw. elastische Verstärkungselemente 12 (Längselemente, z.B. Stahldrähte) in einer ähnlichen Weise um die Kühlleitung 9 angebracht werden, wie dies schon bei den HF-Leitungen 10 der Fall ist. Dies ist in **Fig. 3c** dargestellt. Diese Verstärkungselemente 12 sind so dimensioniert, dass sie für die vorgesehenen Biegeradien und Kräfte gerade genügend flexibel sind. Sie bilden dann eine natürliche Führung des gesamten kalten Aufbaus des Leitungspakets (bestehend aus der jeweiligen Kühlleitung 9 und den zu dieser zugeordneten HF-Leitungen 10) und sorgen dafür, dass keine lokalen Knicks oder Biegungen entstehen können. Dies ist wichtig, um überall nur stetige, gleichmäßige Biegeradien der kalten Elemente zu gewährleisten. Somit werden die Möglichkeiten für maximale lokale Belastungen, die zu vorzeitigen Ermüdungsbrüchen führen könnten, nochmals wesentlich reduziert.

Schließlich werden die Leitungspakete 4 thermisch isoliert und mechanisch gegen den Außenmantel abgestützt. Es ist weiter vorteilhaft, auch diese Leitungspakete 4 miteinander zu verdrillen, mindestens einmal um 360 Grad auf der Länge der flexiblen Verbindungsleitung 8. Die thermische Isolation erfolgt z.B. durch ein zuerst einzelnes und dann gemeinsames Einwickeln mit einer Superisolationsfolie. Dabei können optional auch periodisch Spacer verwendet werden, die die kalten Teile, vorteilhafterweise ausgehend von den harten Ankopplungselementen 11, gegenüber dem Außenmantel abstützen.

Die oben beschriebenen Merkmale führen zu einer flexiblen Verbindungsleitung **8** mit exzellenten Eigenschaften. Bei Tests der kalten Biegsamkeit wurden bei einer Temperatur von ca. 20K und einem Biegeradius von 30 cm eine Anzahl von 1000 Biegezyklen durchgeführt, ohne ein beobachtbares Versagen.

Eine solche Verbindungsleitung ermöglicht es, ein MR-System mit einem gekühlten Vorverstärker, der durch eine flexible, kalte Leitung mit einer kalten Detektionsvorrichtung verbunden ist, zu implementieren. Mit der oben beschriebenen Vorrichtung kann also, ein kalter NMR/MRI Messkopf mit maximaler Performance so einfach wie eine gewöhnliche Raumtemperatur-Messspule in den Magneten eingesetzt werden.

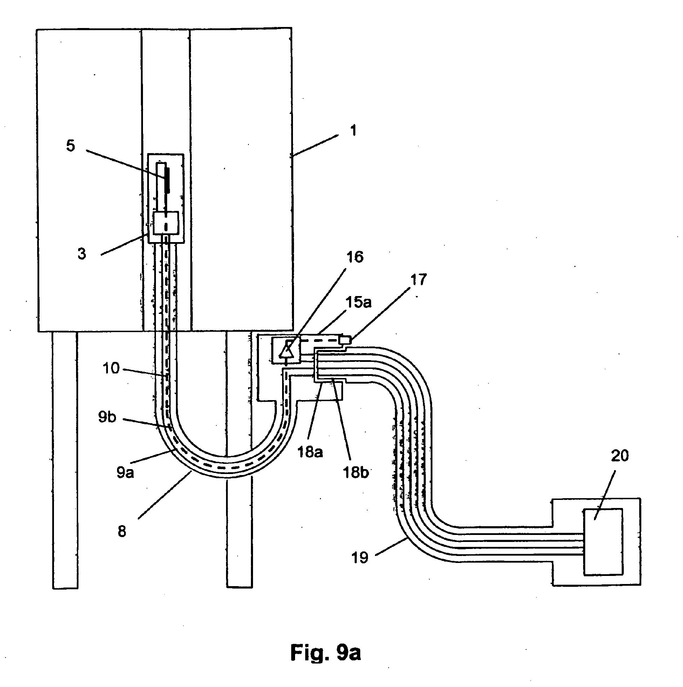

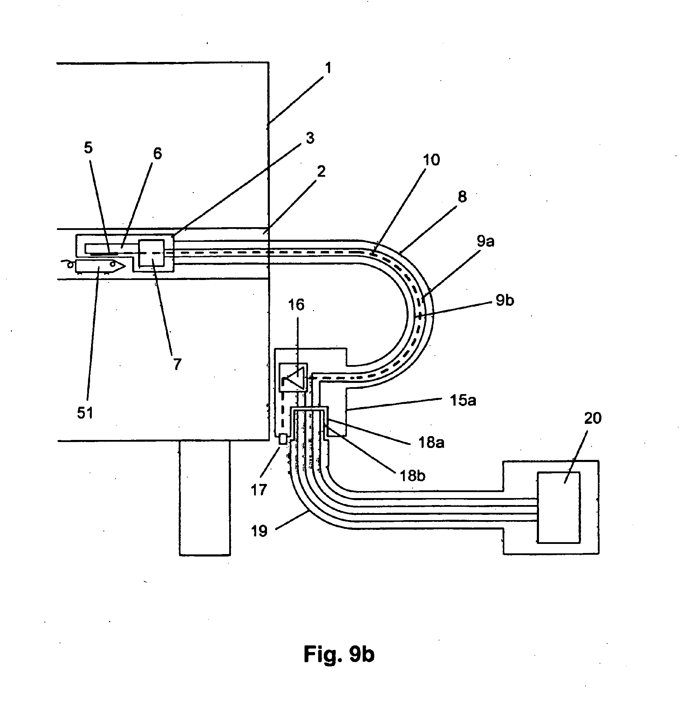

Abschließend zeigen **Fig. 9a** und **Fig. 9b** zwei mögliche MR-Systemkonfigurationen. In Fig. 9a ist ein NMR-System für hochauflösende NMR-Spektroskopie oder Micro-lmaging, in Fig. 9b ein MRI-System für MR-Bildgebung dargestellt.

### Bezugzeichenliste

- 1: Magnet
- 2: Raumtemperaturbohrung des Magneten
- 3: Detektionsvorrichtung
- 4: Leitungspaket
- 5: Empfangsspule
- 6: wärmeleitende Verbindung zur Kühlung der Empfangsspule
- 7: Wärmetauscher zur Kühlung der Empfangsspule
- 8: flexible Verbindungsleitung zwischen Detektionsvorrichtung und Vorverstärker
- 8a: Außenmantel der flexiblen Verbindungsleitung
- 9: flexible Kühlleitung für Spulenkühlung
- 9a: flexible Kühlleitung für Spulenkühlung (Vorlauf)
- 9b: flexible Kühlleitung für Spulenkühlung (Rücklauf)
- 10: flexible HF-Leitung
- 10a: Außenmantel (PTFE) der flexiblen HF-Leitung
- 10b: Außenleiter (Geflecht) der flexiblen HF-Leitung
- 10c: innerer Außenmantel (Metallfolie) der flexiblen HF-Leitung
- 10d: Isolator (PTFE) der flexiblen HF-Leitung
- 10e: Innenleiter der flexiblen HF-Leitung
- 11: Ankopplungselement zwischen Kühlleitung und HF-Leitung zur Kühlung der HF-Leitung
- 12: Verstärkungselement (Stahldraht)
- 13a: Vakuum in der Detektionsvorrichtung
- 14: erster Kühlkreislauf
- 15a: Vorverstärkergehäuse als Teil des Probenkopfes
- 15c: starre Verbindungseinrichtung
- 16: gekühlter Vorverstärker
- 17: Signalausgang am Ausgang des Vorverstärkers
- 18a: vorverstärkerseitiges Kupplungsteil zwischen Vorverstärkergehäuse und Kryokühler
- 18b: kryokühlerseitiges Kupplungsteil zwischen Vorverstärkergehäuse und Kryokühler
- 19: Transferleitung zwischen Kryokühler und Probenkopf
- 20: Kryokühler
- 21a: weiterführende Kühlleitung
- 21b: weiterführende Kühlleitung
- 21c: weiterführende Kühlleitung
- 21d: weiterführende Kühlleitung
- 22: zweiter Kühlkreislauf
- 23: thermische Stufe (Wärmesenke) des oder der gekühlten Vorverstärker
- 51: Messobjekt
- 52: starre HF-Leitung innerhalb Probenkopf
- 54: Pulsrohr-Kühlkopf
- 55: thermisch isoliertes Gehäuse für Pulsrohr- System
- 56: Kompressor für Pulsrohr-Kühlkopf
- 57: flexible Druckleitung zwischen Kompressor und Pulsrohr-Kühlkopf
- 58: Vorverstärker bei Raumtemperatur
- 59: HF Leitung zwischen HF-Spule und Vorverstärker (auf Raumtemperatur)
- 60: LN2 zur Kühlung der Empfangsspule
- 61: thermisch isoliertes Gehäuse (Geschäumtes Polystyrol)
- 62: Wand
- **D1**: erforderlicher Abstand Magnet-Wand, bei starrem Probenkopf
- D2: erforderlicher Abstand Magnet-Wand, bei flexiblem Probenkopf
- Tₚ: Vorverstärkertemperatur
- T_{c}: Temperatur der Empfangsspule
- L: laufende Länge entlang der flexiblen HF-Leitung (Koordinate)

### Referenzliste

[1] WO 2003/050554 A3
[2] DE 196 48 253 A1
[3] DE 199 46 371 C1
[4] "Cryogenic probe setup for routine MR imaging on small animals at 9.4 T", R. Haueisen. D. Marek, M. Sacher, F. Kong, K. Ugurbil, S. Junge, ESMRM Basel, 16. Sept. 2005.
[5] US 5,829,791
[6] US 5,889,456

## Patentansprüche

1. Magnetresonanz(=MR)-Probenkopf
mit einer Detektionsvorrichtung (3) mit mindestens einem von einer Kühlvorrichtung kryogen gekühlten Antennensystem,
sowie mit einem gekühlten Vorverstärker (16) in einem Vorverstärkergehäuse, welches örtlich getrennt von der Detektionsvorrichtung (3) angeordnet ist, und
mit einer thermisch isolierenden Verbindungseinrichtung, über die die Detektionsvorrichtung (3) und das Vorverstärkergehäuse miteinander verbunden sind, wobei die Verbindungseinrichtung mindestens eine Kühlleitung (9, 9a, 9b) für die Zu- und/oder Rückleitung eines Kühl-Fluids, sowie mindestens eine HF-Leitung (10) zur Übertragung der elektrischen Signale umfasst,
**dadurch gekennzeichnet,**
**dass** die Verbindungseinrichtung als eine mechanisch flexible Verbindungsleitung (8) mit mechanisch flexiblen HF- Leitungen (10) und Kühlleitungen (9, 9a, 9b) ausgeführt ist.

2. MR-Probenkopf nach Anspruch 1, **dadurch gekennzeichnet, dass** es sich um einen Probenkopf für Magnetresonanz-Bildgebung(=MRI) - Anwendungen oder für NMR(Kernspinresonanz)-Spektroskopie handelt.

3. MR-Probenkopf nach einem der Ansprüche 1 oder 2, **dadurch gekennzeichnet, dass** mindestens zwei Kühlleitungen (9a, 9b) vorgesehen sind, die Teil eines ersten Kühlkreislaufs (14) sind.

4. MR-Probenkopf nach einem der vorhergehenden Ansprüche, **dadurch gekennzeichnet, dass** jeweils eine oder mehrere HF-Leitungen (10) einer einzelnen Kühlleitung (9, 9a, 9b) zugeteilt sind und dort zusammen mit der zugeteilten Kühlleitung jeweils ein Leitungspaket (4) bilden.

5. MR-Probenkopf nach Anspruch 4, **dadurch gekennzeichnet, dass** die Kühlleitung (9, 9a, 9b) und die der Kühlleitung (9, 9a, 9b) zugeteilten HF-Leitungen (10) eines einzelnen Leitungspaketes (4) in, vorzugsweise regelmässigen, Abständen über thermisch gut leitende Ankopplungselemente (11) miteinander thermisch verbunden sind.

6. MR-Probenkopf nach einem der Ansprüche 4 oder 5, **dadurch gekennzeichnet, dass** zumindest eines der Leitungspakete (4) mindestens ein elastisches Verstärkungselement (12), insbesondere einen Draht hoher mechanischer Festigkeit, enthält.

7. MR-Probenkopf nach einem der Ansprüche 4 bis 6, **dadurch gekennzeichnet, dass** die einzelnen Leitungspakete (4) gegeneinander über die gesamte Länge der Verbindungsleitung (8) vorzugsweise mindestens einmal um die Achse der Verbindungsleitung (8) verdreht sind.

8. MR-Probenkopf nach einem der Ansprüche 5 bis 7, **dadurch gekennzeichnet, dass** innerhalb der Leitungspakete (4) die HF-Leitungen (10) und/oder die elastischen Verstärkungselemente (12) zwischen zwei Ankopplungselementen (11) um im Wesentlichen 360 Grad oder ein ganzzahliges Vielfaches davon mit der Kühlleitung (9, 9a, 9b) verdrillt, insbesondere um die Kühlleitung (9, 9a, 9b) herum gewickelt angebracht sind.

9. MR-Probenkopf nach einem der vorhergehenden Ansprüche, **dadurch gekennzeichnet, dass** die HF-Leitung (10) ein flexibles Koaxialkabel mit vorzugsweise Polytetrafluorethylen (PTFE) Isolation umfasst, bei dem der Außenleiter (10b) aus einer Kombination von einem Metallgeflecht und einer spiralförmig gewickelten, elektrisch gut leitenden Metallfolie besteht.

10. MR-Probenkopf nach einem der vorhergehenden Ansprüche, **dadurch gekennzeichnet, dass** die kalten Teile der Verbindungsleitung (8), insbesondere die Kühlleitungen (9, 9a, 9b) sowie die HF-Leitungen(10), zur thermischen Isolation in einem Vakuum innerhalb mindestens eines flexiblen Außenmantels angeordnet sind.

11. MR-Probenkopf nach einem der vorhergehenden Ansprüche, **dadurch gekennzeichnet, dass** die Elektronik des gekühlten Vorverstärker (16) durch einen von der mindestens einen Kühlleitung (9, 9a, 9b) separaten, zweiten Kühlkreislauf (22) gekühlt wird.

12. MR-Probenkopf nach Anspruch 3 und 11, **dadurch gekennzeichnet, dass** der erste und der zweite Kühlkreislauf (14, 22) von derselben Kühlvorrichtung gekühlt werden.

13. MR-Probenkopf nach einem der vorhergehenden Ansprüche, **dadurch gekennzeichnet, dass** das Antennensystem bei einer tieferen Temperatur betrieben wird als der Vorverstärker (16).

14. MR-Probenkopf nach einem der Ansprüche 5 bis 13, **dadurch gekennzeichnet, dass** der Abstand zwischen dem Vorverstärker (16) und dem vorverstärkerseitig letzten Ankopplungselement größer ist als der durchschnittliche Abstand zweier Ankopplungselemente (11).

15. MR-Probenkopf nach einem der vorhergehenden Ansprüche, **dadurch gekennzeichnet, dass** der Vorverstärker (16) mehrere parallele Vorverstärkerkanäle umfasst.

16. MR-Probenkopf nach Anspruch 2 und 15, **dadurch gekennzeichnet, dass** der Vorverstärker (16) mehrere, insbesondere 2, 3, 4, 6, 8, 12, oder 16 parallele Kanäle für den gleichen zu untersuchenden Kern, insbesondere 1 H, umfasst.

17. MR-Probenkopf nach einem der Ansprüche 2 bis 16, **dadurch gekennzeichnet, dass** der Vorverstärker (16) Kanäle für die Verstärkung der Signale der Kerne 31 P, 13C, 23Na, 19F, 17O, 129Xe oder 2H umfasst.

18. MR-System mit einem MR-Probenkopf nach einem der vorhergehenden Ansprüche.

19. MR-System nach Anspruch 18, **dadurch gekennzeichnet, dass** es sich um ein MRI- oder ein NMR-System handelt.

## Claims

1. Magnetic resonance (MR) probe head comprising a detecting device (3) with at least one antenna system which is cryogenically cooled by a cooling device, and a cooled preamplifier (16) in a preamplifier housing which is spatially separated from the detecting device (3), and a thermally insulating connecting means via which the detecting device (3) and the preamplifier housing are connected, wherein the connecting means comprises at least one cooling line (9, 9a, 9b) for supplying and/or returning a cooling fluid, and at least one RF line (10) for transmitting the electric signals, **characterized in that** the connecting means is implemented as a mechanically flexible connecting line (8) with mechanically flexible RF lines (10) and cooling lines (9, 9a, 9b).

2. MR probe head according to claim 1, **characterized in that** it is a probe head for magnetic resonance imaging (MRI) applications or for NMR (nuclear magnetic resonance) spectroscopy.

3. MR probe head according to either one of the claims 1 or 2, **characterized in that** at least two cooling lines (9a, 9b) are provided which are part of a first cooling circuit (14).

4. MR probe head according to any one of the preceding claims, **characterized in that** one or more RF lines (10) are associated with one single cooling line (9, 9a, 9b), and each form, together with the associated cooling line, one line package (4).

5. MR probe head according to claim 4, **characterized in that** the cooling line (9, 9a, 9b) and the RF lines (10) associated with the cooling line (9, 9a, 9b) of one single line package (4) are thermally connected to each other in preferably regular intervals via coupling elements (11) having good thermal conductivity.

6. MR probe head according to either one of the claims 4 or 5, **characterized in that** at least one of the line packages (4) contains at least one elastic reinforcing element (12), in particular, a wire having high mechanical strength.

7. MR probe head according to any one of the claims 4 through 6, **characterized in that** the individual line packages (4) are twisted about each other, preferably at least once about the axis of the connecting line (8), along the entire length of the connecting line (8).

8. MR probe head according to any one of the claims 5 through 7, **characterized in that** the RF lines (10) and/or the elastic reinforcing elements (12) within the line packages (4) are twisted with the cooling line (9, 9a, 9b) between two coupling elements (11) through substantially 360 degrees or an integer multiple thereof, in particular, wound about the cooling line (9, 9a, 9b).

9. MR probe head according to any one of the preceding claims, **characterized in that** the RF line (10) comprises a flexible coaxial cable with preferably polytetrafluoroethylene (PTFE) insulation, wherein the outer conductor (10b) consists of a combination of a metal braiding and a spirally wound metal foil having good electric conducting properties.

10. MR probe head according to any one of the preceding claims, **characterized in that the** cold parts of the connecting line (8), in particular the cooling lines (9, 9a, 9b) and the RF lines (10), are disposed for thermal insulation in a vacuum within at least one flexible outer jacket.

11. MR probe head according to any one of the preceding claims, **characterized in that** the electronics of the cooled preamplifier (16) is cooled by a second cooling circuit (22) which is separate from the at least one cooling line (9, 9a, 9b).

12. MR probe head according to claims 3 and 11, **characterized in that** the first and the second cooling circuits (14, 22) are cooled by the same cooling device.

13. MR probe head according to any one of the preceding claims, **characterized in that** the antenna system is operated at a lower temperature than the preamplifier (16).

14. MR probe head according to any one of the claims 5 through 13, **characterized in that** the separation between the preamplifier (16) and the last coupling element on the side of the preamplifier is larger than the average separation between two coupling elements (11).

15. MR probe head according to any one of the preceding claims, **characterized in that** the preamplifier (16) comprises several parallel preamplifier channels.

16. MR probe head according to claims 2 and 15, **characterized in that** the preamplifier (16) comprises several, in particular, 2, 3, 4, 6, 8, 12 or 16 parallel channels for the same nucleus to be examined, in particular 1H.

17. MR probe head according to any one of the claims 2 through 16, **characterized in that** the preamplifier (16) comprises channels for amplifying the signals of the nuclei 31P, 13C, 23Na, 19F, 170, 129Xe or 2H.

18. MR system with an MR probe head according to any one of the preceding claims.

19. MR system according to claim 18, **characterized in that** it is an MRI or NMR system.

## Revendications

1. Tête de mesure pour la résonance magnétique (= RM)
avec un dispositif de détection (3) comprenant au moins un système d'antenne refroidi cryogéniquement par un dispositif de refroidissement,
ainsi qu'avec un préamplificateur refroidi (16) dans un carter de préamplificateur qui est disposé de manière localement séparée du dispositif de détection (3), et
avec un équipement de liaison thermiquement isolant via lequel le dispositif de détection (3) et le carter de préamplificateur sont reliés ensemble, l'équipement de liaison comprenant au moins une conduite de refroidissement (9, 9a, 9b) pour l'amenée et/ou le retour d'un fluide de refroidissement ainsi qu'au moins une ligne HF (10) pour la transmission des signaux électriques,
**caractérisée en ce**
**que** l'équipement de liaison est réalisé sous la forme d'une conduite de liaison (8) mécaniquement flexible avec des lignes HF (10) et des conduites de refroidissement (9, 9a, 9b) mécaniquement flexibles.

2. Tête de mesure RM selon la revendication 1, **caractérisée en ce qu'**il s'agit d'une tête de mesure pour des applications d'imagerie par résonance magnétique (= IRM) ou pour la spectroscopie par résonance magnétique nucléaire (= RMN).

3. Tête de mesure RM selon l'une des revendications 1 ou 2, **caractérisée en ce qu'**il est prévu au moins deux conduites de refroidissement (9a, 9b) qui font partie d'un premier circuit de refroidissement (14).

4. Tête de mesure RM selon l'une des revendications précédentes, **caractérisée en ce qu'**une ou plusieurs lignes HF (10) sont chaque fois assignées à une conduite de refroidissement individuelle (9, 9a, 9b) et forment conjointement avec la conduite de refroidissement assignée un paquet de conduites (4).

5. Tête de mesure RM selon la revendication 4, **caractérisée en ce que** la conduite de refroidissement (9, 9a, 9b) et les lignes HF (10) assignées à la conduite de refroidissement (9, 9a, 9b) d'un paquet de conduites individuel (4) sont reliées ensemble thermiquement à intervalles, de préférence réguliers, par des éléments de couplage (11) ayant une bonne conduction thermique.

6. Tête de mesure RM selon l'une des revendications 4 ou 5, **caractérisée en ce qu'**au moins un des paquet de conduites (4) contient au moins un élément de renfort élastique (12), en particulier un fil à haute résistance mécanique.

7. Tête de mesure RM selon l'une des revendications 4 à 6, **caractérisée en ce que** les paquets de conduites individuels (4) sont tournés les uns par rapport aux autres de préférence au moins une fois autour de l'axe de la conduite de liaison (8) sur toute la longueur de la conduite de liaison (8).

8. Tête de mesure RM selon l'une des revendications 5 à 7, **caractérisée en ce qu'**à l'intérieur des paquets de conduites (4), entre deux éléments de couplage (11), les lignes HF (10) et/ou les éléments de renfort élastiques (12) sont torsadés avec la conduite de refroidissement (9, 9a, 9b) d'essentiellement 360 degrés ou d'un multiple entier de ce nombre, en particulier enroulés autour de la conduite de refroidissement (9, 9a, 9b).

9. Tête de mesure RM selon l'une des revendications précédentes, **caractérisée en ce que** la ligne HF (10) comprend un câble coaxial flexible avec isolation de préférence en polytétrafluoréthylène (PTFE), dans lequel le conducteur extérieur (10b) est composé d'une combinaison d'une tresse métallique et d'une feuille métallique enroulée en spirale ayant une bonne conduction électrique.

10. Tête de mesure RM selon l'une des revendications précédentes, **caractérisée en ce que** les parties froides de la conduite de liaison (8), en particulier les conduites de refroidissement (9, 9a, 9b) et les lignes HF (10) sont disposées, pour l'isolation thermique, dans un vide à l'intérieur d'au moins une enveloppe extérieure flexible.

11. Tête de mesure RM selon l'une des revendications précédentes, **caractérisée en ce que** l'électronique du préamplificateur refroidi (16) est refroidie par un deuxième circuit de refroidissement (22) séparé de ladite au moins une conduite de refroidissement (9, 9a, 9b).

12. Tête de mesure RM selon les revendications 3 et 11, **caractérisée en ce que** le premier et le deuxième circuits de refroidissement (14, 22) sont refroidis par le même dispositif de refroidissement.

13. Tête de mesure RM selon l'une des revendications précédentes, **caractérisée en ce que** le système d'antenne fonctionne à une température plus basse que le préamplificateur (16).

14. Tête de mesure RM selon l'une des revendications 5 à 13, **caractérisée en ce que** la distance entre le préamplificateur (16) et le dernier élément de couplage côté préamplificateur est plus grande que la distance moyenne entre deux éléments de couplage (11).

15. Tête de mesure RM selon l'une des revendications précédentes, **caractérisée en ce que** le préamplificateur (16) comprend plusieurs canaux de préamplification parallèles.

16. Tête de mesure RM selon les revendications 2 et 15, **caractérisée en ce que** le préamplificateur (16) comprend plusieurs, en particulier 2, 3, 4, 6, 8, 12 ou 16 canaux parallèles pour le même noyau à étudier, en particulier 1H.

17. Tête de mesure RM selon l'une des revendications 2 à 16, **caractérisée en ce que** le préamplificateur (16) comprend des canaux pour l'amplification des signaux des noyaux 31P, 13C, 23Na, 19F, 170, 129Xe ou 2H.

18. Système RM avec une tête de mesure RM selon l'une des revendications précédentes.

19. Système RM selon la revendication 18, **caractérisée en ce qu'**il s'agit d'un système IRM ou RMN.
